# EUROPEAN PATENT APPLICATION

(11) **EP 1 655 791 A1**
(43) Date of publication of application: **10.05.2006**
(21) Application number: 05255560.4
(22) Date of filing: 09.09.2005
(51) Int. Cl.: H01L 51/05

(54) **Transistor with carbon nanotube channel and method of manufacturing the same**

(30) Priority: 13.09.2004 KR 2004073082
(71) Applicant: Samsung Electronics Co., Ltd., Suwon-si, Gyeonggi-Do (KR)
(72) Inventor: Park, Wan-jun, c/o 19-408 Cheongsil Apt., Seoul (KR); Cheong, Byong-ho, c/o 111-1005 SK Apt., Seoul (KR); Bae, Eun-ju, c/o 104-1506 Dujin Apt., Yongin-si (KR); Kosina, Hans, c/o Insititute fo Microelectronics, 1040 Wien (AT); Mahdi, Pourfath. c/o Inst. for Microelectronics, 1040 Wien (AT)
(74) Representative: Greene, Simon Kenneth

(57) **Abstract**

A transistor with a carbon nanotube channel and a method of manufacturing the same are provided. At least two gate electrodes are formed on a gate insulating layer formed on a carbon nanotube channel and are insulated from each other. Thus, the minority carrier is prevented from flowing into the carbon nanotube channel. Accordingly, it is possible to prevent a leakage current that is generated when both the majority carrier and the minority carrier flow into the carbon nanotube channel. Therefore, characteristics of the transistor can be prevented from being degraded due to the leakage current.

## Description

### BACKGROUND OF THE INVENTION

The present invention relates to a semiconductor device with a carbon nanotube channel and a method of manufacturing the same, and more particularly, to a transistor with a carbon nanotube channel and a method of manufacturing the same.

Carbon nanotubes have a diameter ten thousand times smaller than the diameter of a human hair but are stronger than steel, have both semiconductor and metal properties, and have better performance than silicon. Also, since the carbon nanotubes have mobility seventy times higher than the mobility of silicon at room temperature, the carbon nanotubes can overcome disadvantage of silicon materials, for example, the high noise level of the silicon materials.

Due to these characteristics, the carbon nanotubes are widely used in semiconductor devices, flat panel displays, batteries, super powerful fibers, biosensors, TV cathode ray tubes (CRTs), and so on. The carbon nanotubes are also used as a nanotweezer that can pinch and release a nano-object.

A typical application of the carbon nanotubes is a carbon nanotube transistor of which channel is formed of carbon nanotubes.

In a conventional carbon nanotube transistor (hereinafter, referred to as a conventional transistor), a source electrode and a drain electrode form a Schottky junction together with a carbon nanotube channel.

Therefore, the conventional transistor can be implemented to have the advantages of the carbon nanotubes by forming the channel of the carbon nanotubes.

Hereinafter, the problem of the conventional transistor will be described.

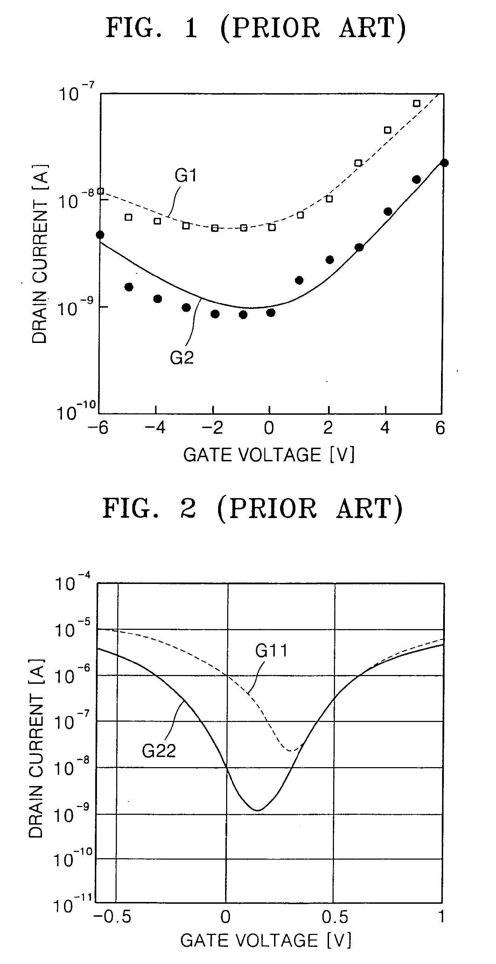

FIG. 1 is a graph illustrating a voltage-current characteristic of a conventional transistor.

In FIG. 1, first and second graphs G1 and G2 represent simulation results at drain voltages of 1.5 V and 0.9 V, respectively. Symbols O and • represent test results at the drain voltages of 1.5 V and 0.9 V, respectively. It is easily seen that the simulation results and the test results are substantially identical to each other.

It can be seen that the voltage-current characteristic according to the voltage applied to the drain electrode of the conventional transistor are not different from that of the graph illustrated in FIG. 1.

FIG. 2 is a graph illustrating voltage-current characteristics of the conventional transistor at the drain voltages of 0.3 V and 0.6 V. In FIG. 2, first and second graphs G11 and G22 represent the voltage-current characteristic at the drain voltages of 0.3 V and 0.6 V, respectively.

In both of the graphs illustrated in FIGS. 1 and 2, the drain current increases from both sides of a gate voltage at which the drain current is minimal.

The drain current at the left side of the gate voltage at which the drain current is minimal is caused by holes, while the drain current at the right side of the gate voltage is caused by electrons.

In the case of a normal transistor, the drain current of a measurement range is caused by the majority carrier, and the drain current caused by the minority carrier can be ignored because it is much lower than the measurement range. For this reason, in the normal transistor, the drain current does not increase at the gate voltage exceeding the voltage at which the drain current is minimal, but has a minimal value.

In the conventional transistors of FIGS. 1 and 2, however, the drain current again increases at the gate voltage exceeding the voltage at which the drain current is minimal.

This result indicates the coexistence of the drain currents in the measurement range, which is caused by the holes and electrons. The existence of the drain current caused by the carriers of the opposite polarities within the measurement range means that the current caused by the minority carrier has a large value that cannot be neglected. The drain current caused by the minority carrier is a current caused by a carrier, which must not be measured at the gate voltage at which the drain current is minimal.

In the conventional transistor, the electrons and the holes flow into the channel as the majority carrier. Therefore, the leakage current may increase and the characteristics of the semiconductor device may be degraded.

### SUMMARY OF THE INVENTION

The present invention provides a transistor with a carbon nanotube channel, which is capable of preventing a minority carrier from flowing into the carbon nanotube channel.

The present invention also provides a method of manufacturing the transistor.

According to an aspect of the present invention, there is provided a transistor including: a substrate; a first insulating layer formed on the substrate; first and second metal layers formed on the first insulating layer and spaced apart from each other by a predetermined distance; a nanotube channel formed on the first insulating layer between the first metal layer and the second metal layer, the nanotube channel having one side contacting the first metal layer and the other side contacting the second metal layer; a second insulating layer covering the first and second metal layers and the nanotube channel; and first and second gate electrodes formed on the second insulating layer formed on the nanotube channel, the first and second gate electrodes being electrically insulated from each other.

The second insulating layer may be a dielectric layer having a dielectric constant higher than that of the first insulating layer.

The first and second gate electrodes may be spaced apart from each other by a predetermined distance.

A third insulating layer is further formed on the second insulating layer to cover the first gate electrode, and the second gate electrode may be formed on the third insulating layer. The first and second gate electrodes may be partially overlapped with each other.

A third gate electrode may be further formed on the second insulating layer, the third gate electrode being insulated from the first and second gate electrodes.

According to another aspect of the present invention, there is provided a method of manufacturing a transistor, including: forming a first insulating layer on a substrate; forming a nanotube channel on the first insulating layer; forming first and second metal layers on the first insulating layer, the first metal layer contacting one side of the nanotube channel and the second metal layer contacting the other side of the nanotube channel; forming a second insulating layer on the first and second metal layers and the nanotube channel; and forming first and second gate electrodes on a region of the second insulating layer which contacts the nanotube layer, the first and second gate electrodes being insulated from each other.

The first and second gate electrodes may be formed with spaced apart from each other by a predetermined distance.

The forming of the first and second gate electrodes may further include:
forming the first gate electrode on the second insulating layer; forming a third insulating layer on the second insulating layer such that the first gate electrode is covered; and forming the second gate electrode on the third insulating layer such that the second gate electrode is overlapped with a portion of the first gate electrode.

A third gate electrode may be further formed on the region of the second insulating layer which contacts the nanotube channel, the third gate electrode being insulated from the first and second gate electrodes.

According to the present invention, it is possible to prevent the minority carrier from flowing into the nanotube channel. Accordingly, it is possible to prevent the leakage current that is generated when both the majority carrier and the minority carrier flow into the nanotube channel. Therefore, characteristics of the transistor can be prevented from being degraded due to the leakage current.

### BRIEF DESCRIPTION OF THE DRAWINGS

The above and other features and advantages of the present invention will become more apparent by describing in detail exemplary embodiments thereof with reference to the attached drawings in which:
FIG. 1 is a graph illustrating simulation and experiment results of a voltage-current characteristic of a conventional carbon nanotube transistor;
FIG. 2 is a graph illustrating a voltage-current characteristic of a conventional carbon nanotube transistor based on the result of FIG. 1;
FIG. 3 is a sectional view of a carbon nanotube transistor according to a first embodiment of the present invention;
FIG. 4 is a sectional view of a carbon nanotube transistor according to a second embodiment of the present invention;
FIG. 5 is a graph illustrating a voltage-current characteristic of the carbon nanotube transistor illustrated in FIGS. 3 and 4;
FIGS. 6 through 9 are sectional views illustrating sequential procedures of manufacturing the carbon nanotube transistor of FIG. 3 according to the first embodiment of the present invention; and
FIGS. 10 through 12 are sectional views illustrating sequential procedures of manufacturing a carbon nanotube transistor of FIG. 4 according to the second embodiment of the present invention.

### DETAILED DESCRIPTION OF THE INVENTION

A transistor with a carbon nanotube channel and a method of manufacturing the same will now be described in detail with reference to the accompanying drawings, in which exemplary embodiments of the invention are shown. In the drawings, the thicknesses of layers and regions are exaggerated for clarity.

First, a transistor according to the present invention will be described below.

### Embodiment 1

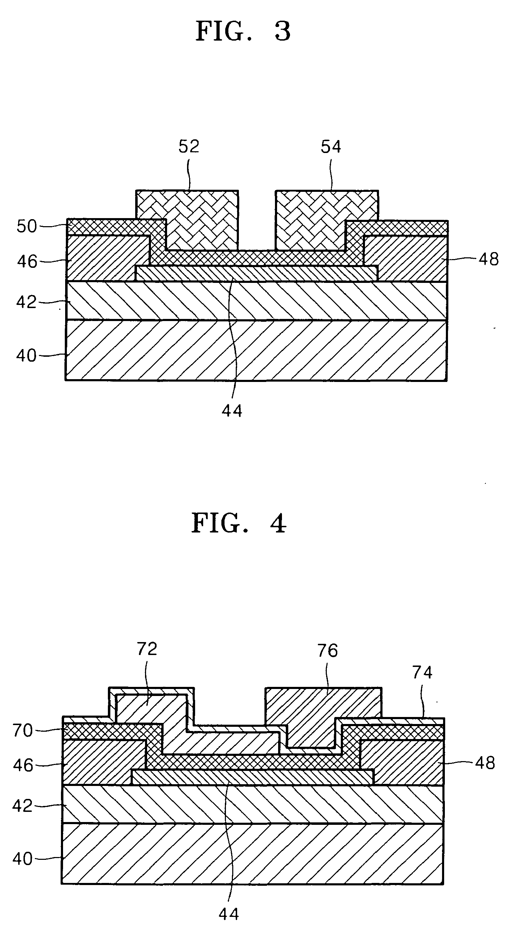

FIG. 3 is a sectional view of a carbon nanotube transistor according to a first embodiment of the present invention.

Referring to FIG. 3, the carbon nanotube transistor (hereinafter, referred to as a first transistor) includes a substrate 40, and a first insulating layer 42 is formed on the substrate 40. Preferably, the first insulating layer 42 is formed of a material having a lower dielectric constant than that of a second insulating layer 50 (which will be described later). The first insulating layer 42 may be formed of SiO₂. Also, a first metal layer 46, a second metal layer 48, and a carbon nanotube channel 44 are formed on the first insulating layer 42. The first and second metal layers 46 and 48 serve as a source and a drain, respectively. The carbon nanotube channel 44 is formed on the first insulating layer 42 between the first metal layer 46 and the second metal layer 48, and contacts the first and second metal layers 46 and 48. Also, the first transistor includes a second insulating layer 50 and first and second gate electrodes 52 and 54. The second insulating layer 50 serves as a gate insulating layer. Preferably, the second insulating layer 50 is formed of a material having a dielectric constant higher than that of the first insulating layer 42. For example, the second insulating layer 50 may be formed of ZrO₃. The second insulating layer 50 is formed on the first and second metal layers 46 and 48 and the carbon nanotube channel 44. The first and second gate electrodes 52 and 54 are disposed above the carbon nanotube channel 44 and spaced apart from each other by a predetermined distance.

When predetermined voltages are applied to the first and second gate electrodes 52 and 54 of the first transistor, a potential leakage occurs. That is, even though the first and second gate electrodes 52 and 54 are spaced apart from each other by the predetermined distance, an electric potential generated by the first and second gate electrodes 52 and 54 leaks to boundaries between the second insulating layer 50 and the first and second gate electrodes 52 and 54 because the second insulating layer 50 is formed of a material with a high dielectric constant. Due to this potential leakage, the second insulating layer 50 disposed between the first gate electrode 52 and the second gate electrode 54 is also influenced by the electric potential generated by the first and second gate electrodes 52 and 54. Accordingly, this electric potential is not concentrated only on one region of the carbon nanotube channel 44, but is uniformly distributed over the entire carbon nanotube channel 44.

In this state, the voltages applied to the first and second gate electrodes 52 and 54 are differently changed to control transmission coefficients of Schottky barriers between the first and second gate electrodes 52 and 54 and the carbon nanotube channel 44. In this manner, an amount of a minority carrier (e.g., a hole in the case of an N-channel transistor) flowing from the second metal layer 48 into the carbon nanotube channel 44 can be controlled.

### Embodiment 2

Like reference numerals in FIGS. 3 and 4 refer to like elements.

FIG. 4 is a sectional view of a carbon nanotube transistor according to a second embodiment of the present invention.

Referring to FIG. 4, the carbon nanotube transistor (hereinafter, referred to as a second transistor) includes first and second metal layers 46 and 48 and a carbon nanotube channel 44 on a first insulating layer 42. The first insulating layer 42 may be formed of a silicon oxide layer or a nitride layer. The first and second metal layers 46 and 48 and the carbon nanotube channel 44 are covered with a second insulating layer 70. The second insulating layer 70 may be formed of a dielectric layer (e.g., a zirconium oxide layer) having a dielectric constant higher than that of the first insulating layer 42, or may be formed of a dielectric layer (e.g., a silicon oxide layer) having a dielectric constant equal to or lower than the first insulating layer 42. A first gate electrode 72 is formed on a predetermined region of the second insulating layer 70. The first gate electrode 72 covers a portion of the carbon nanotube channel 44. The first gate electrode 72 can have the same configuration as the first gate electrode 52 in the first embodiment. A third insulating layer 74 is formed on the second insulating layer 70 such that it covers the first gate electrode 72. The third insulating layer 74 is a dielectric layer with a predetermined dielectric constant. Although the third insulating layer 74 is preferably made of the same dielectric layer as the second insulating layer 70, it can also be different from the second insulating layer 70. The second insulating layer 70 between the second metal layer 48 and the first gate electrode 72 is covered with the third insulating layer 74. A second gate electrode 76 is formed on the third insulating layer 74. The first and second gate electrode 72 and 76 constitute a dual gate electrode. Preferably, the second gate electrode 76 is formed between the first gate electrode 72 and the second metal layer 48. Also, the second gate electrode 76 extends over the first gate electrode 72, so that a portion of the second gate electrode 76 is overlapped with a portion of the first gate electrode 72. Thus, the carbon nanotube channel 44 is all covered with the first and second gate electrodes 72 and 76. Consequently, the entire surface of the carbon nanotube channel 44 faces the gate electrodes 72 and 76. Therefore, even when the second insulating layer 70 does not have a dielectric constant higher than the first insulating layer 42, like in the first embodiment, a uniform electric potential can be applied to the carbon nanotube channel 44.

In this state, the voltages applied to the first and second gate electrodes 72 and 76 are independently controlled. In this manner, it is possible to prevent a minority carrier from flowing into the carbon nanotube channel 44 from the second metal layer 48 serving as the drain.

Next, the voltage-current characteristics of the first and second transistors will now be described.

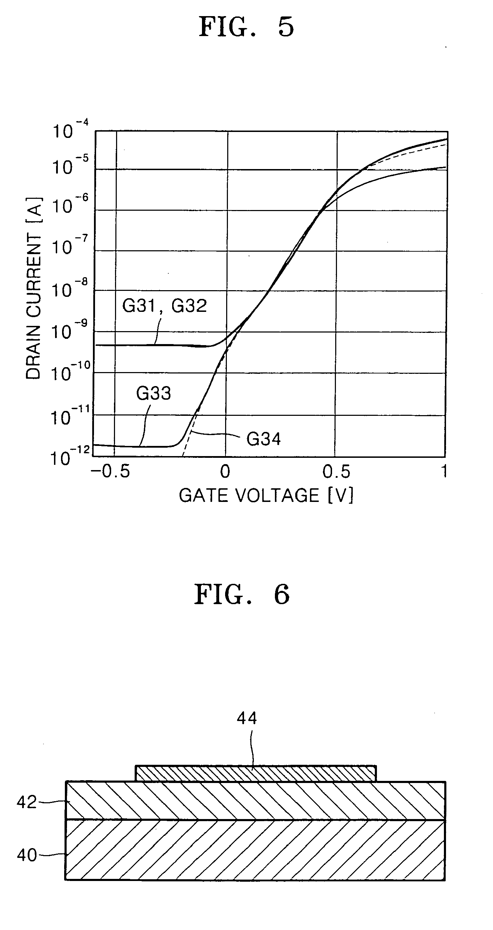

The first and second transistors were configured with N-channel transistors and their voltage-current characteristics were measured. The measurement result is illustrated in FIG. 5.

In FIG. 5, first and second graphs G31 and G32 represent the voltage-current characteristics when the voltage (V_{g2}) (hereinafter, referred to as a second gate voltage) applied to the second gate electrode 54 or 76 is equal to the drain voltage (V_{d}), for example V_{d} = 0.3 V and V_{d} = 0.6. This case will be referred to as a first case. Third and fourth graphs G33 and G34 represent the voltage-current characteristics when the second gate voltage (V_{g2}) is different from the drain voltage (V_{d}). This case will be referred to as a second case. Specifically, the third graph G33 represents the voltage-current characteristic when the second gate voltage (V_{g2}) and the drain voltage (V_{d}) are 0.8 V and 0.3 V, respectively. The fourth graph represents the voltage-current characteristic when the second gate voltage (V_{g2}) and the drain voltage (V_{d}) are 0.8 V and 0.6 V, respectively.

In the first case, as can be seen from the first and second graphs G31 and G32, the drain current increases as the voltage (hereinafter, referred to as a first gate voltage) applied to the first gate electrode 52 or 72 becomes higher than 0 V, and the drain current decreases as the first gate voltage becomes lower than 0 V. However, when the first gate voltage is lower than 0 V, the drain current does not decreases any more, but maintains a predetermined value as the first gate voltage becomes lower than a predetermined voltage.

In the second case, as can be seen from the third and fourth graphs G33 and G34 the drain current decreases as the first gate voltage becomes lower than 0 V. As the first gate voltage becomes lower than a predetermined voltage, the drain current does not decrease any more, but maintains a predetermined value.

In both of the cases, the drain current does not increase when the first gate voltage decreases. These results show that the minority carrier (i.e., the hole) is prevented from flowing into the carbon nanotube channel from the drain. Therefore, the probability that the leakage current can be generated is much , reduced.

When the first and second transistors are P-channel transistors, the opposite results can be obtained.

That is, in the case of the P-channel transistors, when predetermined negative voltages are applied to the second gate electrodes 54 and 76 and the drain, the drain current gradually increases as the first gate voltage becomes lower than 0 V. On the contrary, the current decreases as the first gate voltage becomes higher than 0 V, and the drain current maintains a predetermined value as the first gate voltage becomes higher than a predetermined voltage. These results show that the minority carrier (i.e., an electron) is prevented from flowing into the carbon nanotube channel from the drain.

Next, methods of manufacturing the first and second transistors will be described below.

First, the method of manufacturing the first transistor will now be described with reference to FIGS. 6 through 9.

Referring to FIG. 6, a first insulating layer 42 is formed on a substrate 40. The first insulating layer 42 may be formed of a silicon oxide layer, or a dielectric layer with a low dielectric constant. A carbon nanotube channel 44 is formed on a predetermined region of the first insulating layer 42.

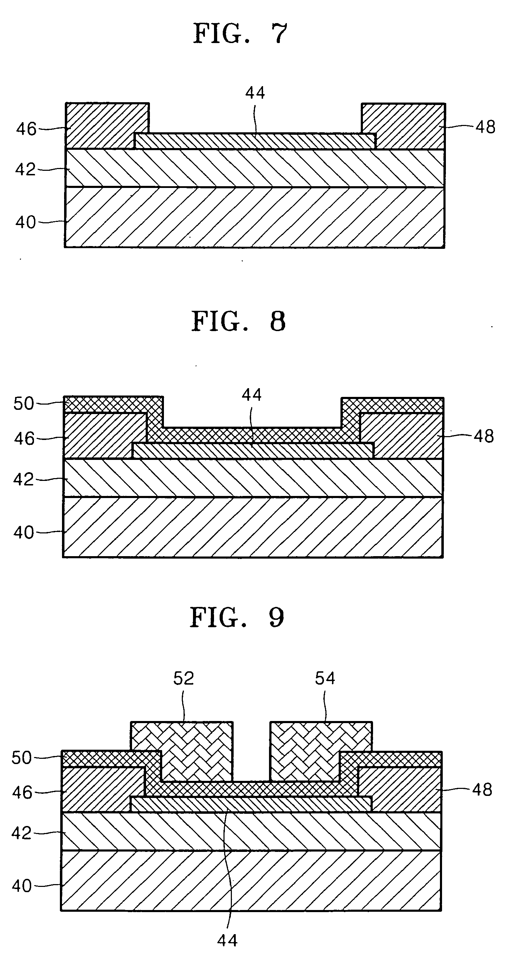

Referring to FIG. 7, first and second metal layers 46 and 48 are formed on the first insulating layer 42. The first metal layer 46 contacts one side of the carbon nanotube channel 44 and the second metal layer 48 contacts the other side of the carbon nanotube channel 44. The first metal layer 46 and the second metal layer 48 serve as a source and a drain, respectively.

Referring to FIG. 8, a second insulating layer 50 is formed on the first and second metal layers 46 and 48 and the carbon nanotube channel 44. Preferably, the second insulating layer 50 is formed of a dielectric layer having a higher dielectric constant than that of the first insulating layer 42. For example, the second insulating layer 50 may be formed of a zirconium oxide layer (ZrO₃).

Referring to FIG. 9, first and second gate electrodes 52 and 54 are formed on the second insulating layer 50 by using a photolithography. Both of the first and second gate electrodes 52 and 54 are disposed above the carbon nanotube channel 44 and can be spaced apart from each other by a predetermined distance. Even when the first and second gate electrodes 52 and 54 are separated from each other, since the second insulating layer 50 has a high dielectric constant, electric potential applied to the carbon nanotube channel 44 exposed between the first and second gate electrodes 52 and 54 is equal to electric potential applied to below the first and second gate electrodes 52 and 54.

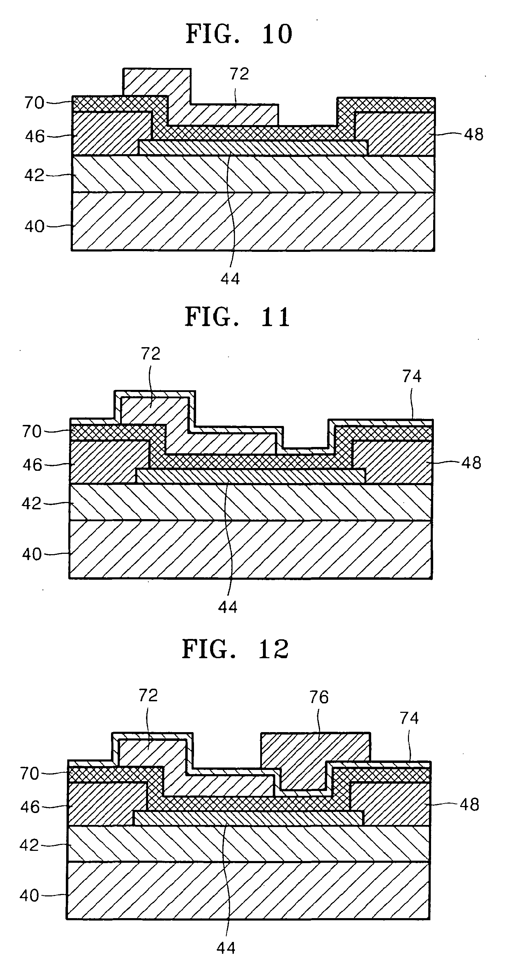

Next, the method of manufacturing the second transistor will now be described with reference to FIGS. 10 through 12.

Referring to FIG. 10, first and second metal layers 46 and 48 and a carbon nanotube channel 44 are formed on a first insulating layer 42 by using the method of manufacturing the first transistor. Then, a second insulating layer 70 is formed to cover the first and second metal layers 46 and 48 and the carbon nanotube channel 44. The second insulating layer 70 may be formed of a silicon oxide layer. Also, the second insulating layer 70 may be formed of a dielectric layer having a dielectric constant equal to or higher than that of the first insulating layer 42. Further, the second insulating layer 70 may be formed of a nitride layer. Then, a first gate electrode 72 is formed on the second insulating layer 70. The forming of the first gate electrode 72 can include depositing a conductive material on the second insulating layer 70, planarizing a surface of the deposited conductive layer, and patterning the planarized conductive layer using a photolithography. Therefore, although the top surface of the first gate electrode 72 is stepped in FIG. 10, the top surface of the first gate electrode 72 can also be flat. Preferably, the first gate electrode 72 is formed above the carbon nanotube channel 44 such that a portion of the carbon nanotube channel 44 is covered.

Referring to FIG. 11, a third insulating layer 74 is formed to cover the resulting structure, that is, to cover the second insulating layer 70 and the first gate electrode 72. The third insulating layer 74 may be formed of a material layer equal to the second insulating layer 70, or may be other material layers.

Referring to FIG. 12, a second gate electrode 76 is formed on a predetermined region of the third insulating layer 74. The second gate electrode 76 can be formed using the same manner as in the case of the first gate electrode 72. Preferably, the second gate electrode 76 may be formed to cover the carbon nanotube channel 44 between the first gate electrode 72 and the second metal layer 48. Also, the second gate electrode 76 may be overlapped with a portion of the first gate electrode 72.

The first and second gates 72 and 76 can be formed in a reverse sequence. That is, the second gate electrode 76 can be formed on the second insulating layer 70 and the first gate electrode 72 can be formed on the third insulating layer 74. Also, more than two gate electrodes can be provided.

As described above, the carbon nanotube transistor according to the present invention includes at least two gate electrodes insulated from each other and thus it has a uniform electric potential in the entire region of the channel due to different dielectric constants of the insulating layer between the substrate and the channel and the insulating layer between the channel and the gate electrode. Also, the transmission coefficients of the Schottky barriers between the carbon nanotube channel and the source and drain can be adjusted by applying independent voltages to the gate electrodes. Accordingly, the minority carrier is prevented from flowing into the carbon nanotube channel. Consequently, it is possible to prevent the occurrence of the leakage current that is generated when both the majority carrier and the minority carrier flow into the channel. Therefore, it is possible to prevent characteristic degradation of the transistors due to the leakage current.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A transistor comprising:
a substrate;
a first insulating layer formed on the substrate;
first and second metal layers formed on the first insulating layer and spaced apart from each other by a predetermined distance;
a nanotube channel formed on the first insulating layer between the first and second metal layers, the nanotube channel having one side contacting the first metal layer and the other side contacting the second metal layer;
a second insulating layer covering the first and second metal layers and the nanotube channel; and
first and second gate electrodes formed on the second insulating layer formed on the nanotube channel, the first and second gate electrodes being electrically insulated from each other.

2. The transistor of claim 1, wherein the second insulating layer is a dielectric layer having a dielectric constant higher than that of the first insulating layer.

3. The transistor of claim 1 or 2, wherein the first and second gate electrodes are spaced apart from each other by a predetermined distance.

4. The transistor of claim 1, 2 or 3, further comprising a third insulating layer formed on the second insulating layer to cover the first gate electrode.

5. The transistor of claim 4, wherein the second gate electrode is disposed on the third insulating layer, the first and second gate electrodes being partially overlapped with each other.

6. The transistor of any preceding claim, further comprising a third gate electrode formed on the second insulating layer, the third gate electrode being insulated from the first and second gate electrodes.

7. A method of manufacturing a transistor, comprising:
forming a first insulating layer on a substrate;
forming a nanotube channel on the first insulating layer;
forming first and second metal layers on the first insulating layer, the first metal layer contacting one side of the nanotube channel, the second metal layer contacting the other side of the nanotube channel;
forming a second insulating layer on the first and second metal layers and the nanotube channel; and
forming first and second gate electrodes on a region of the second insulating layer which contacts the nanotube layer, the first and second gate electrodes being insulated from each other.

8. The method of claim 7, wherein the second insulating layer is formed of a dielectric layer having a dielectric constant higher than that of the first insulating layer.

9. The method of claim 7 or 8, wherein the first and second gate electrodes are formed with spaced apart from each other by a predetermined distance.

10. The method of claim 7, 8 or 9, wherein the forming of the first and second gate electrodes further comprises:
forming the first gate electrode on the second insulating layer;
forming a third insulating layer on the second insulating layer such that the first gate electrode is covered; and
forming the second gate electrode on the third insulating layer such that the second gate electrode is overlapped with a portion of the first gate electrode.

11. The method of claim 7, 8, 9 or 10, further comprising forming a third gate electrode on the region of the second insulating layer which contacts the nanotube channel, the third gate electrode being insulated from the first and second gate electrodes.
